# EUROPÄISCHE PATENTSCHRIFT

(11) **EP 0 838 989 B1**
(45) Veröffentlichungstag und Bekanntmachung des Hinweises auf die Patenterteilung: **08.03.2000**
(21) Anmeldenummer: 97116946.1
(22) Anmeldetag: 30.09.1997
(51) Int. Cl.: H05K 9/00, H05K 7/14

(54) **Abgeschirmter Baugruppenträger**
Shielded electronic rack
Baie électronique blindée

(30) Priorität: 25.10.1996 DE 19644414
(43) Veröffentlichungstag der Anmeldung: 29.04.1998
(73) Patentinhaber: Schroff GmbH, D-75334 Straubenhardt (DE)
(72) Erfinder: Günther, Hans-Ulrich, 76327 Pfinztal (DE); Mazura, Paul, 76302 Karlsbad (DE); Haag, Volker, 75323 Bad Wildbad (DE); Pfeifer, Klaus, 76199 Karlsruhe (DE); Thalau, Klaus-Michael, 76316 Malsch (DE); Joist, Michael, 76571 Gaggenau (DE); Weiss, Udo, 753345 Straubenhardt (DE)
(74) Vertreter: Durm, Klaus, Dr.-Ing.

(56) Entgegenhaltungen:
- EP-A- 0 695 118
- DE-C- 4 110 800
- DE-U- 29 509 102
- DE-U- 29 602 426

## Beschreibung

Die Erfindung betrifft einen abgeschirmten Baugruppenträger für auf Führungsschienen einschiebbare Leiterkarten mit elektrischen oder elektronischen Bauelementen. Der Baugruppenträger umfaßt zwei parallele, metallische Seitenwände und wenigstens vier parallel verlaufende, metallische Modulschienen, welche die Seitenwände verbinden und die Führungsschienen tragen. Die Leiterkarten sind mit jeweils einer Frontplatte zu einschiebbaren und ausziehbaren Steckbaugruppen zusammengefaßt, während die vorderen Modulschienen je eine zur Vorderseite des Baugruppenträgers offene Nut zur Aufnahme eines Gewindelochstreifens und jeweils wenigstens eine Anlagefläche für die Frontplatten der Steckbaugruppen aufweisen.

Insbesondere digitale elektronische Schaltungen, deren Schaltpegel zunehmend niedriger gewählt werden, reagieren empfindlich auf hochfrequente Störfelder in der Umgebung. Daher müssen Baugruppenträger mit Leiterkarten, welche derart empfindliche Schaltungen tragen, allseitig abgeschirmt sein. Zu diesem Zweck verwendet man hochfrequenzdichte Seitenwände, Deck- und Bodenbleche sowie rückwärtige Hauben. Die Abschirmung gegen hochfrequente Störfelder im Frontplattenbereich ist demgegenüber durch das Erfordernis, daß einzelne Leiterkarten jederzeit herausziehbar sein sollen, ungleich problematischer. Insbesondere wenn der Baugruppenträger nicht mit einer Gesamt-Frontplatte versehen ist, die sich über die gesamte Breite des Baugruppenträgers erstreckt, sondern Steckbaugruppen aufnimmt, bei denen die eingeschobenen Leiterkarten mit einzelnen Frontplatten fest verbunden sind, bereiten die Spalte zwischen den Frontplatten und dem Baugruppenträger, speziell an den Modulschienen, besondere Probleme.

Die Abschirmung der vertikalen Spalte zwischen den Frontplatten bzw. zwischen den Frontplatten und den Seitenwänden wird üblicherweise mit Federelementen vorgenommen, wie sie beispielsweise in der Patentschrift DE 41 10 800 C1 der Anmelderin beschrieben sind. Dort werden auf die Schenkel einer U-förmig ausgebildeten Frontplatte metallische Federelemente aufgesetzt, die sich beim Einschieben der Steckbaugruppe gegen die angrenzende Frontplatte oder gegen die Seitenwand des Baugruppenträgers pressen und so den erforderlichen niederohmigen und flächigen Kontakt herstellen.

Für die horizontale Kontaktierung der Frontplatten an den Modulschienen sind unterschiedliche Lösungswege beschritten worden. Aus der DE 41 26 576 A1 ist beispielsweise ein Federelement bekannt, welches in die nach vorne offene Nut einer Modulschiene eingeschoben wird und in einem vor dem Gewindelochstreifen angeordneten erweiterten Abschnitt der Nut sitzt. Dieses Federelement weist einen abgewinkelten Streifen auf, der über die Nut der Modulschiene nach vorne übersteht und beim Einschieben einer Steckbaugruppe von der Frontplatte gegen eine elastische Federkraft in Richtung des Gewindelochstreifens bewegt wird.

Auch aus der DE 296 02 426 U1 ist ein Kontaktierungselement bekannt, welches in der nach vorne offenen Nut einer Modulschiene sitzt und vor dem Gewindelochstreifen angeordnet ist. Bei diesem Stand der Technik wird die Kontaktierung mit den Frontplatten der Steckbaugruppen durch periodisch angeordnete, nach vorne über die Modulschiene überstehende Kontaktdorne hergestellt.

Den bekannten Kontaktierungselementen ist gemeinsam, daß sie zwischen den Frontplatten und den Gewindelochstreifen in den Nuten der Modulschienen sitzen, so daß die Schrauben zur Befestigung der Steckbaugruppen durch die Kontaktierungselemente hindurch in die Gewindelochstreifen eingedreht werden müssen. Die Kontaktierungselemente müssen daher im Teilungsraster der Gewindelochstreifen Lücken aufweisen. Außerdem müssen diese Lücken mit den Gewindelöchern fluchten, was einen nicht unbeträchtlichen Mehraufwand bei der Montage eines solchen Baugruppenträgers erfordert.

Neben der Anbringung von Kontaktierungselementen in der Nut einer Modulschiene ist es prinzipiell möglich, die Anlageflächen der Modulschienen mit Kontaktierungselementen zu versehen. Dabei ist jedoch zu beachten, daß die Anlageflächen der Modulschienen als Abdrückflächen für Steckbaugruppen-Aushebegriffe dienen. Bei Steckbaugruppen mit einer dreireihig bestückten, 96-poligen Steckverbindung kann die Aushebekraft, die von einem solchen Steckbaugruppen-Aushebegriff auf die Anlagefläche der Modulschiene aufgebracht wird, bis zu 100 N betragen. Die Entwicklungen bei Elektronik-Leiterkarten führen dabei in naher Zukunft zu einer weiteren Steigerung der notwendigen Aushebekräfte.

Bekannte Abschirmelemente, die im Bereich der Anlageflächen der Modulschienen angeordnet werden, sind daher auf die Innenseiten der Frontplatten geklebt, wobei der Bereich der Aushebegriffe ausgespart wird. Eine solche Vorgehensweise erfordert ein sehr präzises Arbeiten beim Aufkleben der Abschirmelemente, da diese beim Einschieben der Steckbaugruppe exakt auf den Anlageflächen der Modulschienen aufliegen müssen.

Der vorliegenden Erfindung liegt daher die Aufgabe zugrunde, einen abgeschirmten Baugruppenträger der eingangs genannten Art so weiterzubilden, daß eine gegen hochfrequente Störfelder abgeschirmte Verbindung zwischen den Frontplatten der Steckbaugruppen und den Modulschienen auf einfache, aber wirkungsvolle Weise gewährleistet ist, wobei die Nuten der Modulschienen zwischen den Frontplatten und den Gewindelochstreifen freibleiben sollen, während eine Beschädigung der Kontaktierungselemente durch Aushebemechanismen für die Steckbaugruppen ausgeschlossen sein soll.

Diese Aufgabe ist durch einen abgeschirmten Baugruppenträger mit den Merkmalen des Anspruchs 1 gelöst.

Vorteilhafte Ausgestaltungen und Weiterbildungen der Erfindung sind in den Ansprüchen 2 bis 9 beschrieben.

Erfindungsgemäß werden also die Modulschienen eines abgeschirmten Baugruppenträgers der eingangs genannten Art so modifiziert, daß sie hinter ihren Anlageflächen je eine obere und eine untere Eingriffsnut aufweisen. Zur sicheren Kontaktierung der Frontplatten mit den Modulschienen sind Kontaktfederbänder vorgesehen, die auf die Anlageflächen der Modulschienen aufschnappbar sind, wobei sie die Anlageflächen oben und unten hintergreifen und so elastisch in die Eingriffsnuten einrasten. Die Kontaktfederbänder sind mit einer Anzahl von federnd zur Vorderseite des Baugruppenträgers weisenden Ausbrechungen sowie mit einer Anzahl von zur Anlagefläche weisenden Kontaktkrallen versehen. Mit derart durch einfaches Aufschnappen auf die Modulschienen anbringbaren Kontaktfederbändern ist es sogar möglich, einen Baugruppenträger im Bereich der Frontplatten nachträglich hochfrequenzdicht abzuschirmen.

Die federnde Ausbildung der Ausbrechungen der Kontaktfederbänder erfordert, daß die Frontplatten der Steckbaugruppen gegen die Federkraft der Ausbrechungen an die Modulschienen angedrückt werden müssen. Die Ausbrechungen werden dabei elastisch verformt und dringen in die Oberfläche der Innenseiten der Frontplatten ein, so daß ein sicherer elektrischer Kontakt auch durch eine Oxidschicht hindurch hergestellt wird. Gleichzeitig werden die scharfkantigen Kontaktkrallen an den Rückseiten der Kontaktfederbänder gegen die Anlageflächen der Modulschienen gedrückt, wodurch die Kontaktierung mit den Modulschienen sichergestellt wird.

Insbesondere wenn das erfindungsgemäße Kontaktfederband im wesentlichen aus einem ebenen Metallblech besteht, dessen obere und untere Ränder derart abgebogen sind, daß sie in die jeweiligen Eingriffsnuten der Modulschienen eingreifen, ist kaum zu befürchten, daß die Kontaktfederbänder durch Aushebemechanismen beschädigt werden; denn die ebenen Bereiche der Kontaktfederbänder können beim Ausheben einer Steckbaugruppe nicht beschädigt werden. Da die Ausbrechungen und die Kontaktkrallen nur in gewissen Abständen auf den Kontaktfederbändern verteilt sind, ist die Wahrscheinlichkeit hoch, daß ein Steckbaugruppen-Aushebemechanismus sich auf einen ebenen Abschnitt eines Kontaktfederbandes abstützt.

Beschädigungen der Kontaktfederbänder durch Aushebemechanismen können dann gänzlich ausgeschlossen werden, wenn die Ausbrechungen der Kontaktfederbänder aus einem im wesentlichen vertikalen Einschnitt und zwei von diesem ausgehenden, dreieckförmig abgebogenen Federblättern bestehen. Zweckmäßigerweise sind die Federblätter dabei derart ausgelegt, daß ein Anpressen an die Anlagefläche der Modulschiene noch im elastischen Verformungsbereich der Federblätter liegt. Da Steckbaugruppen-Aushebemechanismen üblicherweise so arbeiten, daß sie sich in vertikaler Richtung abrollend gegen die Anlageflächen der Modulschienen abstützen, ist die Herstellung der Ausbrechungen durch einen vertikalen Einschnitt, welcher der Abdrückbewegung des Aushebemechanismusses keinen Widerstand entgegensetzt, vorteilhaft. Sollte sich ein Aushebegriff gerade an der Stelle einer Ausbrechung auf dem Kontaktfederband abstützen, geben also die dreieckförmig abgebogenen Federblätter lediglich elastisch nach, wobei sie nicht beschädigt werden.

Die Kontaktkrallen der Kontaktfederbänder können auf einfache Weise mittels einer scharfkantigen Materialausstülpung hergestellt werden.

Wenn die Kontaktfederbänder aus einer Anzahl von jeweils gleichen Abschnitten bestehen, zwischen denen jeweils eine Sollbruchstelle angeordnet ist, kann das Kontaktfederband endlos hergestellt und bei der hochfrequenzdichten Abschirmung des Baugruppenträgers auf die jeweils erforderliche Länge gekürzt werden. Die Sollbruchstellen ermöglichen dabei, daß das Kontaktfederband mit bloßen Händen in der gewünschten Länge abgebrochen werden kann.

Wenn der untere Rand der Kontaktfederbänder durch eine Auflaufschräge verlängert ist, wird die Handhabung beim Aufschnappen eines Kontaktfederbandes auf eine Modulschiene verbessert.

Vorzugsweise bestehen die Kontaktfederbänder aus Chrom-Nickel-Stahl. Dieses Material korrodiert nicht, zeigt eine hohe Eigenelastizität sowie eine gute Leitfähigkeit und kontaktiert sehr gut mit Aluminium, das bevorzugt als Material für die Modulschienen und die Frontplatten gewählt wird.

Besondere Vorteile ergeben sich, wenn die Anlageflächen der Modulschienen zumindest bereichsweise blankgefräst oder blankgeschliffen sind. Denn üblicherweise bestehen die Modulschienen aus eloxierten Aluminiumprofilen, die eine harte und beständige Oberfläche aufweisen. Eine eloxierte Aluminiumoberfläche verkratzt also kaum; darüber hinaus ist eine ungleichmäßige Korrosion während eines Transports oder bei der Lagerhaltung nicht zu befürchten. Der Nachteil einer eloxierten Aluminiumoberfläche besteht jedoch in der geringen elektrischen Leitfähigkeit der Eloxalschicht. Für gegen hochfrequente Störfelder abgeschirmte Baugruppenträger werden daher bislang Modulschienen verwendet, die nach der Bearbeitung chemisch von der Eloxalschicht vollständig befreit wurden.

Wird dagegen nur die zur Kontaktierung der Modulschienen mit den Frontplatten vorgesehene Anlagefläche durch Fräsen oder Schleifen mechanisch von ihrer Eloxalschicht befreit, kann ein Baugruppenträger mit derart nachbearbeiteten Modulschienen auch noch nachträglich hochfrequenzsicher abgeschirmt werden. Dies ist gegenüber dem Stand der Technik, nach dem entweder vollständig eloxierte Aluminiumprofile oder alternativ vollständig von der Eloxalschicht befreite Aluminiumprofile als Modulschienen verwendet wurden, ein weiterer großer Fortschritt.

Ein Ausführungsbeispiel der Erfindung wird im folgenden anhand der beigefügten Zeichnungen näher beschrieben. Es zeigen:
- Figur 1: eine schematische Ansicht eines Baugruppenträgers;
- Figur 2: die Kontaktierung einer Modulschiene mit einer Frontplatte;
- Figur 3: eine perspektivische Ansicht zweier Kontaktfederbänder;
- Figur 4: eine Schnittdarstellung eines Kontaktfederbandes, welches auf eine Modulschiene aufgeschnappt wird.

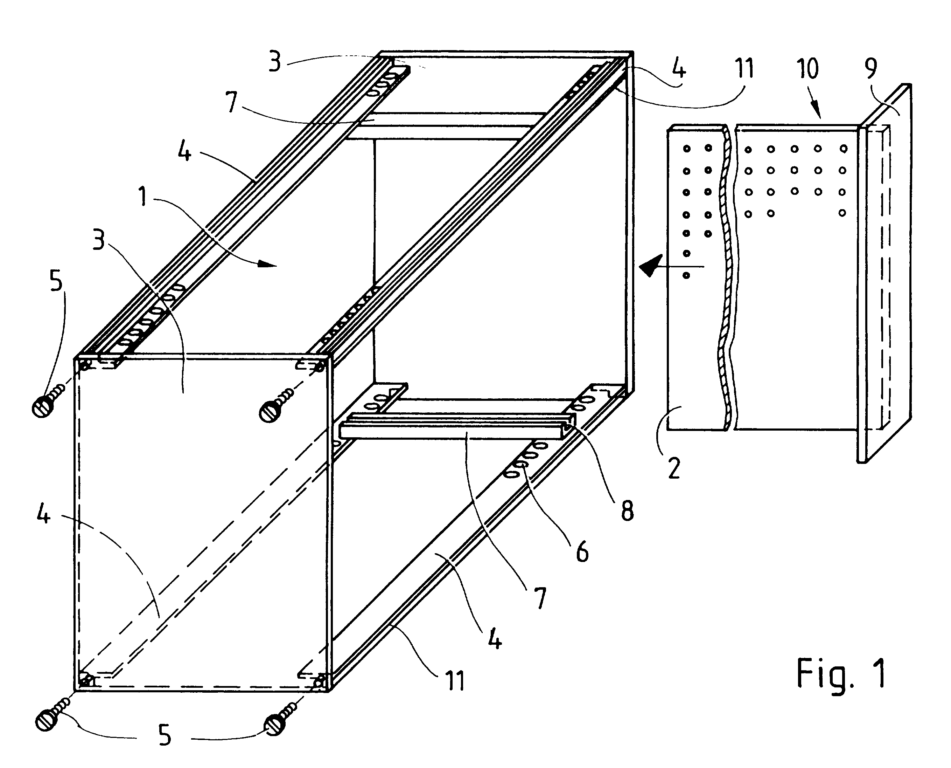

In Figur 1 ist ein Baugruppenträger 1 zur Aufnahme von Leiterkarten 2 mit (nicht dargestellten) elektronischen Bauelementen schematisch in einer perspektivischen Ansicht dargestellt. Der gezeigte Baugruppenträger 1 umfaßt zwei Seitenwände 3 und vier Modulschienen 4, welche die Seitenwände 3 verbinden und an diesen mittels Befestigungsschrauben 5 befestigt sind. Die Modulschienen 4 weisen in einem bestimmten Abstandsraster Langlöcher 6 auf, in welche obere und untere Führungsschienen 7 eingesteckt werden können. Die Führungsschienen 7 sind jeweils mit einer Führungsnut 8 zur Aufnahme der Leiterkarten 2 versehen. Die dargestellte Leiterkarte 2, die aus Gründen der Übersichtlichkeit verkürzt abgebildet ist, ist fest mit einer Frontplatte 9 verbunden und bildet mit dieser eine Steckbaugruppe 10. Die vorderen Modulschienen 4 enthalten eine nach vorne offene Nut 11.

In Figur 1 nicht dargestellt sind Deck- und Bodenplatten sowie eine rückwärtige Haube und weitere Frontplattenelemente, die für eine Abschirmung gegen hochfrequente Störfelder selbstverständlich noch vorhanden sein müssen.

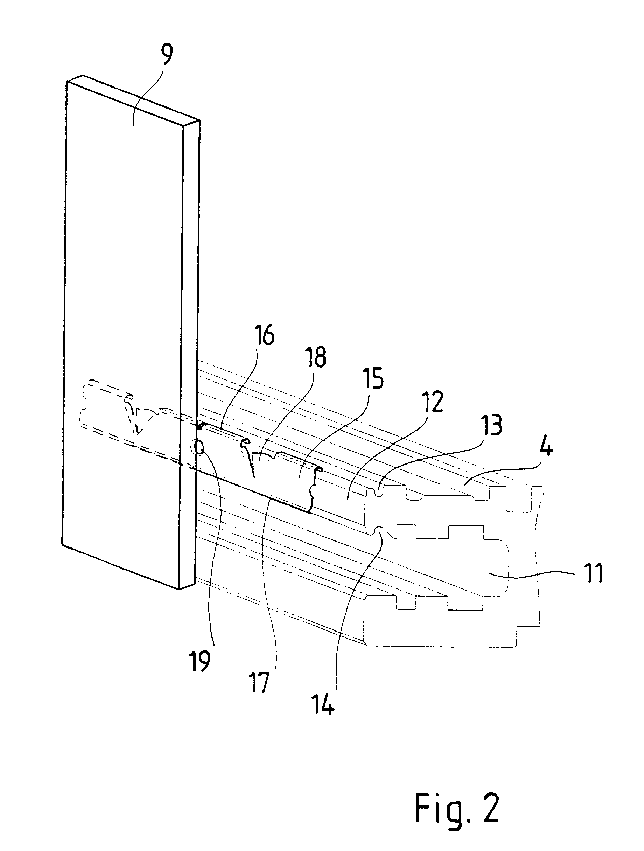

Figur 2 zeigt schematisch die Kontaktierung zwischen einer Modulschiene 4 und einer Frontplatte 9 einer Steckbaugruppe 10 nach der Erfindung. Die Modulschiene 4 weist eine nach vorne offene Nut 11 auf, in deren inneren erweiterten Bereich ein hier nicht dargestellter Gewindelochstreifen eingeschoben wird. Eine ebenfalls nicht dargestellte Befestigungsschraube kann zur Sicherung der eingeschobenen Steckbaugruppe 10 durch eine Befestigungsöffnung in der Frontplatte 9 hindurchgeführt und in ein Gewindeloch des Gewindelochstreifens eingeschraubt werden.

Oberhalb der Nut 11 weist die Modulschiene 4 eine blankgefräste Anlagefläche 12 auf. Hinter dieser Anlagefläche 12 sind eine obere Eingriffsnut 13 und eine untere Eingriffsnut 14 zu erkennen. Auf der Anlagefläche 12 sitzt ein Kontaktfederband 15, welches aus einem ebenen Edelstahlblech besteht und dessen oberer Rand 16 und dessen unterer Rand 17 derart abgebogen sind, daß sie in die obere Eingriffsnut 13 bzw. in die untere Eingriffsnut 14 eingreifen. Das Kontaktfederband 15 ist mit der Modulschiene 4 lediglich dadurch verbunden, daß es auf die Anlagefläche 12 aufgeschnappt ist. Deutlich zu erkennen sind die nach vorne weisenden Ausbrechungen 18 des Kontaktfederbandes 15, welche den elektrischen Kontakt mit der Frontplatte 9 herstellen, sowie die zur Anlagefläche 12 zeigenden Kontaktkrallen 19, die den elektrischen Kontakt mit der Modulschiene 4 gewährleisten.

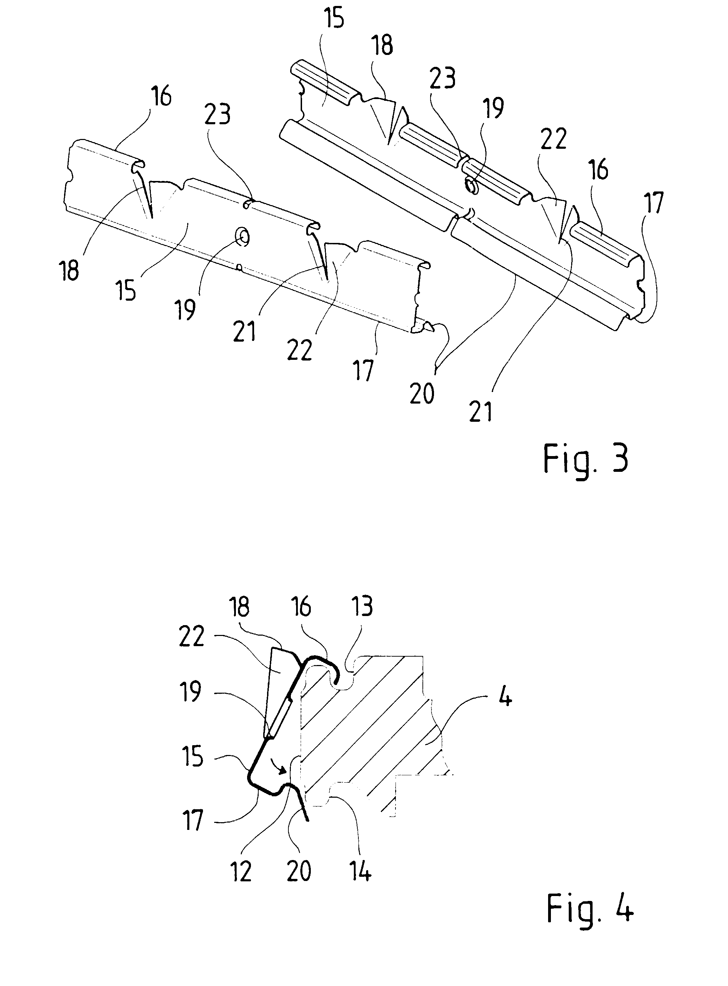

Figur 3 zeigt eine perspektivische Ansicht zweier Kontaktfederbänder 15. Diese bestehen aus Edelstahlblechen, deren obere Ränder 16 zweifach abgekantet sind. Die unteren Ränder 17 der Metallbleche sind in entsprechender Weise zweifach abgekantet und setzen sich in einer Auflaufschräge 20 fort. In der Mitte der Kontaktfederbänder 15 ist jeweils eine scharfkantige Materialausstülpung erkennbar, die als Kontaktkralle 19 dient. Daneben sind jeweils zwei Ausbrechungen 18 dargestellt, die jeweils aus einem vertikalen Einschnitt 21 und zwei dreieckförmig abgebogenen Federblättern 22 bestehen. Beide dargestellten Kontaktfederbänder 15 weisen jeweils zwei gleiche Abschnitte auf, die mittels einer Sollbruchstelle 23 durch einfaches Abbrechen voneinander getrennt werden können. Die für einen Baugruppenträger zu verwendenden Kontaktfederbänder 15 bestehen normalerweise aus mehr als zwei durch eine Sollbruchstelle 23 getrennten Abschnitten.

Figur 4 illustriert das Aufschnappen eines Kontaktfederbandes 15 auf eine Modulschiene 4. Das Kontaktfederband 15, dessen Kontaktkrallen 19 und dessen Ausbrechungen 18 mit dem Federblatt 22 gut zu erkennen sind, wird zunächst an dem zweifach abgekanteten oberen Rand 16 in die obere Eingriffsnut 13 der Modulschiene 4 eingesetzt. Danach wird der ebenfalls zweifach abgekantete untere Rand 17 des Kontaktfederbandes 15 mit Hilfe der Auflaufschräge 20 in die untere Eingriffsnut 14 eingeschnappt, so daß sich im Ergebnis das Kontaktfederband 15 auf die Anlagefläche 12 der Modulschiene 4 anlegt und durch die Elastizität des Edelstahls festgehalten wird.

### Zusammenstellung der Bezugszeichen

- 1: Baugruppenträger
- 2: Leiterkarte
- 3: Seitenwände
- 4: Modulschienen
- 5: Befestigungsschrauben
- 6: Langlöcher
- 7: Führungsschienen
- 8: Führungsnut
- 9: Frontplatte
- 10: Steckbaugruppe
- 11: Nut
- 12: Anlagefläche
- 13: obere Eingriffsnut
- 14: untere Eingriffsnut
- 15: Kontaktfederband
- 16: oberer Rand (von 15)
- 17: unterer Rand (von 15)
- 18: Ausbrechungen
- 19: Kontaktkrallen
- 20: Auflaufschräge
- 21: Einschnitt
- 22: Federblätter
- 23: Sollbruchstelle

## Patentansprüche

1. Abgeschirmter Baugruppenträger für auf Führungsschienen einschiebbare Leiterkarten (2) mit elektrischen oder elektronischen Bauelementen, mit zwei parallelen, metallischen Seitenwänden (3) und wenigstens vier parallel verlaufenden, metallischen Modulschienen (4), welche die Seitenwände verbinden und die Führungsschienen tragen, wobei die Leiterkarten (2) mit jeweils einer Frontplatte (9) zu einschiebbaren und ausziehbaren Steckbaugruppen zusammengefaßt sind, während die vorderen Modulschienen je eine zur Vorderseite des Baugruppenträgers offene Nut (11) zur Aufnahme eines Gewindelochstreifens und jeweils wenigstens eine Anlagefläche (12) für die Frontplatten der Steckbaugruppen aufweisen, dadurch **gekennzeichnet**, daß die Modulschienen (4) hinter ihren Anlageflächen (12) je eine obere Eingriffsnut (13) und eine untere Eingriffsnut (14) aufweisen und daß auf die Anlagefläche (12) aufschnappbare Kontaktfederbänder (15) vorgesehen sind, welche durch Hintergreifen der Anlagefläche (12) in die Eingriffsnuten (13, 14) elastisch einrasten und eine Anzahl von federnd zur Vorderseite des Baugruppenträgers (1) weisende Ausbrechungen (18) sowie eine Anzahl von zur Anlagefläche (12) weisenden Kontaktkrallen (19) aufweisen.

2. Abgeschirmter Baugruppenträger nach Anspruch 1, dadurch **gekennzeichnet**, daß die Kontaktfederbänder (15) im wesentlichen aus einem ebenen Metallblech bestehen, dessen obere und untere Ränder (16, 17) derart abgebogen sind, daß sie in die jeweiligen Eingriffsnuten (13, 14) der zugehörigen Modulschienen (4) eingreifen.

3. Abgeschirmter Baugruppenträger nach einem der Ansprüche 1 oder 2, dadurch **gekennzeichnet**, daß die Ausbrechungen (18) der Kontaktfederbänder (15) jeweils aus einem im wesentlichen vertikalen Einschnitt (21) und zwei von diesem ausgehenden, dreieckförmig abgebogenen Federblättern (22) bestehen.

4. Abgeschirmter Baugruppenträger nach Anspruch 3, dadurch **gekennzeichnet**, daß die Federblätter (22) derart ausgelegt sind, daß ein Anpressen der Federblätter (22) an die Anlageflächen (12) der Modulschienen (4) noch im elastischen Verformungsbereich liegt.

5. Abgeschirmter Baugruppenträger nach einem der Ansprüche 1 bis 4, dadurch **gekennzeichnet**, daß die Kontaktkrallen (19) der Kontaktfederbänder (15) durch scharfkantige Materialausstülpungen gebildet sind.

6. Abgeschirmter Baugruppenträger nach einem der Ansprüche 1 bis 5, dadurch **gekennzeichnet**, daß die Kontaktfederbänder (15) aus einer Anzahl von jeweils gleichen Abschnitten bestehen, zwischen denen jeweils eine Sollbruchstelle (23) angeordnet ist.

7. Abgeschirmter Baugruppenträger nach einem der Ansprüche 1 bis 6, dadurch **gekennzeichnet**, daß die unteren Ränder (17) der Kontaktfederbänder (15) durch Auflaufschrägen (20) verlängert sind.

8. Abgeschirmter Baugruppenträger nach einem der Ansprüche 1 bis 7, dadurch **gekennzeichnet**, daß die Kontaktfederbänder (15) aus Chrom-Nickel-Stahl bestehen.

9. Abgeschirmter Baugruppenträger nach einem der Ansprüche 1 bis 8, dadurch **gekennzeichnet**, daß die Anlageflächen (12) der Modulschienen (4) zumindest bereichsweise blankgefräst oder blankgeschliffen sind.

## Claims

1. Shielded sub-rack for printed circuit boards (2), which can be pushed in on guide rails, with electrical or electronic components, with two parallel metallic side walls (3) and at least four metallic module rails (4), which extend in parallel, connect the side walls and bear the guide rails, wherein the printed circuit boards (2) are assembled with a respective front panel (9) to form plug-in units which can be pushed in and withdrawn, while the front module rails each comprise a groove (11) open towards the front side of the sub-rack to accommodate a threaded hole strip and at least one locating face (12) for the front panels of the plug-in units, characterised in that the module rails (4) each comprise an upper engagement groove (13) and a lower engagement groove (14) behind their locating faces (12), and that contact spring strips (15) are provided which can snap onto the locating face (12), lock elastically into the engagement grooves (13, 14) by engaging behind the locating face (12) and comprise a number of break-out parts (18), which point resiliently towards the front side of the sub-rack (1), and a number of contact claws (19), which point towards the locating face (12).

2. Shielded sub-rack according to Claim 1, characterised in that the contact spring strips (15) consist substantially of a plane metal sheet, the upper and lower edges (16, 17) of which are bent such that they engage in the respective engagement grooves (13, 14) of the associated module rails (4).

3. Shielded sub-rack according to Claim 1 or 2, characterised in that the break-out parts (18) of the contact spring strips (15) each consist of a substantially vertical cut (21) and two spring leaves (22) extending from the latter and bent in the shape of triangles.

4. Shielded sub-rack according to Claim 3, characterised in that the spring leaves (22) are designed such that the pressing thereof against the locating faces (12) of the module rails (4) occurs still within the elastic deformation region.

5. Shielded sub-rack according to any one of Claims 1 to 4, characterised in that the contact claws (19) of the contact spring strips (15) are formed by sharp-edged material protuberances.

6. Shielded sub-rack according to any one of Claims 1 to 5, characterised in that the contact spring strips (15) consist of a number of like portions, between which a respective predetermined breaking point (23) is disposed.

7. Shielded sub-rack according to any one of Claims 1 to 6, characterised in that the lower edges (17) of the contact spring strips (15) are lengthened by leading bevels (20).

8. Shielded sub-rack according to any one of Claims 1 to 7, characterised in that the contact spring strips (15) consist of chromium-nickel steel.

9. Shielded sub-rack according to any one of Claims 1 to 8, characterised in that the locating faces (12) of the module rails (4) are milled bare or abraded bare, at least in regions.

## Revendications

1. Baie blindée pour cartes à circuits imprimés (2) pouvant être insérées dans des rails de guidage, comportant des composants électriques ou électroniques, comprenant deux parois (3) latérales, métalliques, parallèles et au moins quatre rails modulaires (4) métalliques disposés parallèlement qui raccordent les parois latérales et supportent les rails de guidage, où les cartes à circuits imprimés (2) sont respectivement fixées ensemble par une plaque frontale (9) sur des modules enfichables qui peuvent être introduits et sortis, tandis que les rails modulaires avant comportent chacun une rainure ouverte (11) formée sur la face de départ de la baie pour recevoir une bande à trous taraudés et, selon le cas, comportent au moins une face de départ (12) destinée aux plaques frontales des modules enfichables, caractérisée en ce que les rails modulaires (4) comportent chacun, derrière leur face de départ (12), une rainure d'engagement supérieure (13) et une rainure d'engagement inférieure (14) et en ce que des bandes à ressort de contact (15) pouvant être fixées de façon instantanée sur les faces de départ (12) sont prévues, lesquelles, au moyen d'une saisie par l'arrière de la face de départ (12) s'enclenchent de manière élastique dans les rainure d'engagement (13,14) et comportent un certain nombre de cassures (18) à effet de ressort indiquées sur la face de départ de la baie (1), de même qu'un certain nombre de griffes de contact indiquées sur les faces de départ (12).

2. Baie blindée selon la revendication 1, caractérisée en ce que les bandes à ressort de contact (15) sont essentiellement constituées d'une tôle métallique plate dont les bords supérieur et inférieur (16,17) sont repliés de manière à s'encliqueter dans les rainures d'engagement (13,14) respectives des rails modulaires (4) correspondants.

3. Baie blindée selon l'une quelconque des revendications 1 ou 2 , caractérisée en ce que les cassures (18) des bandes à ressort de contact (15) sont respectivement constituées d'une entaille (21) essentiellement verticale et de deux lames de ressort (22) formant saillie repliées en forme de triangle.

4. Baie blindée selon la revendication 3, caractérisée en ce que les lames de ressort (22) sont disposées de manière telle qu'une pression exercée par les lames de ressort (22) sur les faces de départ (12) des rails modulaires (4) ne s'applique que dans la zone de déformation élastique.

5. Baie blindée selon l'une quelconque des revendications 1 à 4, caractérisée en ce que les griffes de contact (19) des bandes à ressort de contact (15) sont réalisées au moyen d'un matériau formant saillie à bord effilé.

6. Baie blindée selon l'une quelconque des revendications 1 à 5, caractérisée en ce que les bandes à ressort de contact (15) sont constituées d'un certain nombre de sections respectivement identiques entre lesquelles est formé un point destiné à la rupture.

7. Baie blindée selon l'une quelconque des revendications 1 à 6 , caractérisée en ce que les bords inférieurs (17) des bandes à ressort de contact (15) sont prolongés par le chanfrein incliné (20).

8. Baie blindée selon l'une quelconque des revendications 1 à 7 , caractérisée en ce que les bandes à ressort de contact (15) sont constituées de chrome/nickel/acier.

9. Baie blindée selon l'une quelconque des revendications 1 à 8, caractérisée en ce que les faces de départ (12) des rails modulaires (4) sont, au moins localement, fraisées ou polies par usinage.
